# EUROPEAN PATENT SPECIFICATION

(11) **EP 3 927 651 B1**
(45) Date of publication and mention of the grant of the patent: **29.05.2024**
(21) Application number: 19710845.9
(22) Date of filing: 22.02.2019
(51) Int. Cl.: B81B 7/00, B81C 1/00, H01H 1/00

(54) **FULL SYMMETRIC MULTI-THROW SWITCH USING CONFORMAL PINCHED THROUGH VIA**
VOLLSYMMETRISCHER MEHRFACHSCHALTER MIT KONFORMEM DURCHKONTAKTIERTEM DURCHGANG
INTERRUPTEUR MULTIPOSITIONS PARFAITEMENT SYMÉTRIQUES UTILISANT UN TROU D'INTERCONNEXION CONFORMÉ À STRICTION

(43) Date of publication of application: 29.12.2021
(73) Proprietor: Menlo Microsystems, Inc., Irvine, CA 92618 (US)
(72) Inventor: ZHU, Xu, Albany, NY 12203 (US); EVANS, Darryl, Albany, NY 12203 (US); KEIMEL, Chris, Albany, NY 12203 (US)
(74) Representative: Marks & Clerk LLP
(86) International application number: PCT/US2019/019160
(87) International publication number: WO 2020/171821

(56) References cited:
- US-A1- 2004 259 325
- US-A1- 2014 184 352
- US-A1- 2014 253 260
- US-A1- 2015 353 348

## Description

### BACKGROUND

Certain devices, such as switches, may not operate reliably and consistently when exposed to uncontrolled operational environmental conditions. Moisture and contamination could cause an increase in early device failures. Accordingly, it is common practice to contain such devices within a protective package, which, at least to some extent, separates an internal device environment from an external environment. The packaging, however, may be susceptible to certain weak points. Package seams, for example, can provide an opportunity for a leak between the package interior and the external environment. Electrical connections, which electrically couple the device to components in the external environment, must pass from the external environment into the device environment and to the device. Device packages may use a "via," or multiple vias, which are shaped voids in the package walls, to convey a conductor through the package from the external environment to the device environment. Such vias generally provide an opportunity for the external environment to impinge upon the device environment. One technique of using a via to implement an electrical connection through a package wall is known as a plated via. A plated via is typically a cylindrical void formed in a package wall, with metal deposited, grown, or otherwise deployed on the walls of the void. Plated vias provide a conductive path from the outside of the package to the inside of the package, but leaves a void from the outside to the inside of the package.

US 2004/259325 A1 discloses an hermetically sealed package for a microelectromechanical (MEMS) or for an integrated circuit (IC) device in a cavity where a glass post or pillar containing an electrical feedthrough via extends from the inner surface of a glass cap to the device.

US 2015/353348 A1 discloses a glass hermetically sealed package for a MEMS device where a feedthrough via is made by conformally coating conductive material on the side walls of an hourglass shaped hole in the cap. The conformal coating joins itself to hermetically seal the feedthrough at the waist of the hourglass shaped hole.

Even when an effort has been made to seal the vias, the seal may be difficult to maintain over operating and storage temperature extremes due to expansion and contraction of the package and conductors within the vias.

### SUMMARY

A component and a method of fabricating such a component are defined by the independent claims. Preferred embodiments are defined in the dependent claims. We describe device packages that enclose a device within a hermetically sealed cavity. The cavity encompasses the device within a device environment, and isolates the device from an external environment. Electrical connections from the device to components in the external environment are achieved through vias in the device package. The vias are configured to implement a hermetic seal between the device and external environments, and to maintain the seal over operating and storage temperature ranges of the device.

In the device of the invention the hermetic seal is accomplished with a conformal pinched via (CPV), which is configured to accommodate differences between the coefficient of thermal expansion (CTE) of the package material through which the via passes, and the material of the CPV. Placing the CPV in a wall of the package above the device allows for accessing electrical ports directly, without requiring a signal path to traverse the device substrate prior to reaching the device port.

We describe a hermetically sealed component, comprising a glass substrate, and a device associated with the glass substrate. The device may have at least one electrical port. The hermetically sealed component may further comprise a glass cap, at least one side wall, a void extending through the glass cap and a glass pillar from a top surface of the glass cap to a bottom surface of the glass pillar, and an electrically conductive plug disposed within the void. The electrically conductive plug may be configured to be electrically coupled to the at least one electrical port and to hermetically seal the void. The glass cap and the glass substrate may be arranged with the at least one side wall disposed therebetween, to form a cavity encompassing the device. The at least one side wall may be contacting the glass substrate and the glass cap to provide a hermetic seal, such that a first environment within the cavity is isolated from a second environment external to the cavity, and the electrically conductive plug contacting the electrical port.

The device may be one of a microelectromechanical system (MEMS)-based device, and a nanoelectromechanical system (NEMS) device and (iii) an ohmic switch. The hermetic seal may be configured such that a measured helium leak rate is less than 1.0 × 10-6 (atm-cm)3/second. The glass substrate and the glass cap may comprise one or more of (i) silicon dioxide (SiO2), (ii) fused silica, (iii) silica glass, (iv) quartz, (v) sodium-doped glass, and (vi) borosilicate glass. The device may be associated with the glass substrate by being integrated on the glass substrate using a series deposition-lithography-pattern etch process.

The electrically conductive plug may be electrically coupled to the at least one electrical port by metal thermo-compression bonding.

A bond between the side wall and one or both of the glass cap and the glass substrate may be implemented by one of (i) metal compression, (ii) eutectic bonding, (iii) laser bonding, (iv) glass frit, and (v) anodic wafer bonding.

The void is hourglass-shaped, and the electrically conductive plug and the void forms a conformal pinched via (CPV). The glass cap may further comprise a re-distribution layer disposed on a top surface of the glass cap and electrically coupled to the electrically conductive plug. The re-distribution layer may comprise at least one of gold, aluminum, and copper. The void may have a diameter less than 500 µm in a plane defined by the top surface of the glass cap. A portion of the cavity, defined by the glass cap and the at least one side wall, may be formed such that the glass cap and the at least one side wall comprise a single, integrated component. A portion of the cavity, defined by the glass substrate and the at least one side wall, may be formed such that the glass substrate and the at least one side wall comprise a single, integrated component.

The device may comprise one of (i) a single throw ohmic switch and (ii) a multi-throw ohmic switch. The device may consist of metal, polysilicon, or both.

The electrically conductive plug of the CPV may expand or contract to mitigate a difference between a coefficient of thermal expansion (CTE) of the glass cap and a CTE of the electrically conductive plug. The device may comprise two or more distinct devices.

The hermetically sealed component may further comprise an additional void extending through the glass substrate from a bottom surface of the glass substrate to a top surface of the glass substrate, with an additional electrically conductive plug disposed within the void. The additional electrically conductive plug may be configured to be electrically coupled to an additional one of the at least one electrical port, and to hermetically seal the void.

We describe a hermetically sealed component fabricated together with a plurality of hermetically sealed components, comprising a glass substrate, and at least two devices associated with the glass substrate. Each of the at least two devices may have at least one electrical port. The hermetically sealed component fabricated together with a plurality of hermetically sealed components may further comprise a glass cover comprising a glass cap for each of the at least two devices. Each of the glass caps may have (i) at least one side wall, (ii) a void extending through the glass cap and a glass pillar from a top surface of the glass cap to a bottom surface of the glass pillar, and (iii) an electrically conductive plug disposed within the void. The electrically conductive plug may be configured to be electrically coupled to the at least one electrical port of a respective device and to hermetically seal the void. The glass cover may be disposed on the glass substrate such that each of the at least two glass caps covers a corresponding device on the glass substrate to form a cavity encompassing the device. The at least one side wall may be attached to the glass substrate to provide a hermetic seal, such that a first environment within the cavity is isolated from a second environment external to the device package.

We also describe a method of fabricating a plurality of device packages, comprising fabricating at least two devices directly on a glass substrate, each of the at least two devices having at least one electrical port, and fabricating a glass cover that comprises at least two glass caps, one for each of the two devices. Each of the at least two glass caps may have (i) at least one side wall, (ii) a void extending through the glass cap and a glass pillar from a top surface of the glass cap to a bottom surface of the glass pillar, and (iii) an electrically conductive plug disposed within the void. The electrically conductive plug may be configured to be electrically coupled to the at least one electrical port of a respective device and to hermetically seal the void. The method may further comprise disposing the glass cover on the glass substrate, each of the at least two glass caps covering a corresponding device on the glass substrate, thereby forming a cavity that encompasses the corresponding device. The method may further comprise attaching the at least one side wall to the glass and the glass substrate to provide a hermetic seal, thereby isolating a first environment within the cavity from a second environment external to the device package, and electrically coupling each of the electrically conductive plugs to a respective electrical port.

We describe a package hosting a symmetrical switch, comprising a switch having at least one pole corresponding to a first contact and at least two throws associated with at least a second contact and a third contact. The switch may be disposed on a surface of a glass substrate, and the second contact and the third contact may be symmetrically distributed about the first contact. The package hosting a symmetrical switch may further comprise a glass cap having at least one side wall. For each of the first contact and the at least second and third contacts, the package hosting a symmetrical switch may further comprise (i) a void extending through the glass cap and a glass pillar from a top surface of the glass cap to a bottom surface of the glass pillar, and (ii) an electrically conductive plug disposed within the void, the electrically conductive plug configured to be electrically coupled to the at least one electrical port and to hermetically seal the void. The glass cap may be disposed on the glass substrate to form a cavity encompassing the device. The at least one side wall may contact the glass substrate to provide a hermetic seal, such that a first environment within the cavity is isolated from a second environment external to the device package. The switch may be a multi-pole, multi-throw switch comprising two or more poles each corresponding to a respective pole contact.

We also describe a package hosting a single pole, single throw switch, comprising a switch having a pole corresponding to a first contact and a throw associated with at least a second contact. The switch may be disposed on a surface of a glass substrate. The package hosting a single pole, single throw switch may further comprise a glass cap having at least one side wall. For each of the first contact and the second contact, the package hosting a single pole, single throw switch may further comprise (i) a void extending through the glass cap and a glass pillar from a top surface of the glass cap to a bottom surface of the glass pillar, and (ii) an electrically conductive plug disposed within the void. The electrically conductive plug may be configured to be electrically coupled to the at least one electrical port and to hermetically seal the void. The glass cap may be disposed on the glass substrate to form a cavity encompassing the device. The at least one side wall may contact the glass substrate to provide a hermetic seal, such that a first environment within the cavity is isolated from a second environment external to the device package.

We also describe a device package, comprising a symmetrically configured device having at least a first contact, a second contact, and a third contact. The symmetrically configured device may be disposed on a surface of a glass substrate. The second contact and the third contact may be symmetrically distributed about the first contact with respect to the surface of the glass substrate. The device package may further comprise a glass cap having at least one side wall. For each of the at least first contact, second contact and third contact, the package may further comprise (i) a void extending through the glass cap and a glass pillar from a top surface of the glass cap to a bottom surface of the glass pillar, and (ii) an electrically conductive plug disposed within the void. The electrically conductive plug may be configured to be electrically coupled to the at least one electrical port and to hermetically seal the void. The glass cap may be disposed on the glass substrate to form a cavity encompassing the symmetrically configured device. The at least one side wall may contact the glass substrate to provide a hermetic seal, such that a first environment within the cavity is isolated from a second environment external to the device package.

### BRIEF DESCRIPTION OF THE DRAWINGS

The patent or application file contains at least one drawing executed in color. Copies of this patent or patent application publication with color drawings will be provided by the Office upon request and payment of the necessary fee.

The foregoing will be apparent from the following more particular description of example embodiments, as illustrated in the accompanying drawings in which like reference characters refer to the same parts throughout the different views. The drawings are not necessarily to scale, emphasis instead being placed upon illustrating embodiments.
FIG. 1A shows an example of a hermetically sealed component falling outside the scope of the invention.
FIG. 1B illustrates an exploded view of the component shown in FIG. 1A.
FIG. 1C shows another example embodiment of a hermetically sealed component.
FIG. 1D shows an exploded view of the example embodiment shown in FIG. 1C.
FIG. 1E shows another example embodiment of a hermetically sealed component.
FIG. 1F shows yet another example embodiment of a hermetically sealed.
FIG. 2A shows a cross-sectional view of an hourglass-shaped void according to the invention.
FIG. 2B shows a cross-sectional view of an embodiment of the metallic plug of a conformal pinched via, according to the invention
FIG. 2C illustrates a cross-sectional view of another embodiment of the metallic plug of a conformal pinched via.
FIG. 3A illustrates an example of a wafer-scale hermetically sealed package.
FIG. 3B shows an exploded view of the wafer-scale hermetically sealed package assembly of FIG. 3A.
FIG. 3C shows a plurality of devices arranged in a two-dimensional grid array on a common substrate.
FIG. 4A illustrates a top view of an example single pole, four-throw MEMS.
FIG. 4B illustrates an isometric view of the MEMS switch depicted in FIG. 4A.
FIG. 5 illustrates an example embodiment of a method of fabricating a plurality of device packages.

### DETAILED DESCRIPTION

A description of example embodiments follows.

The teachings of all patents, published applications and references cited herein are incorporated by reference in their entirety.

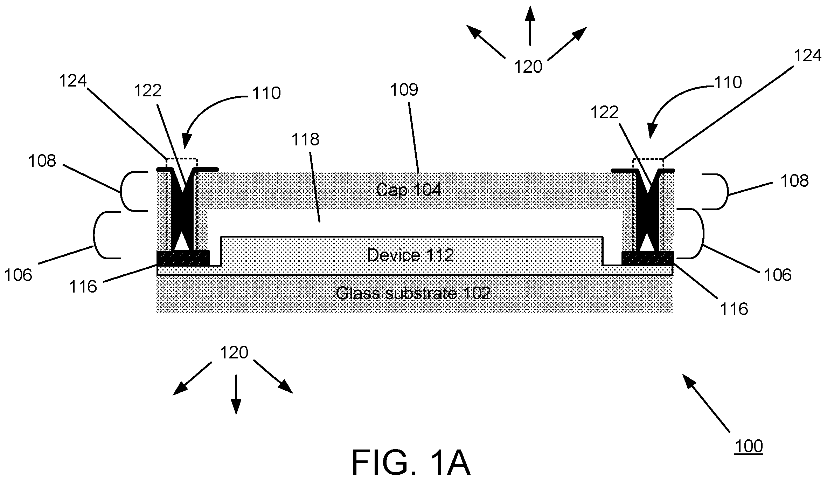

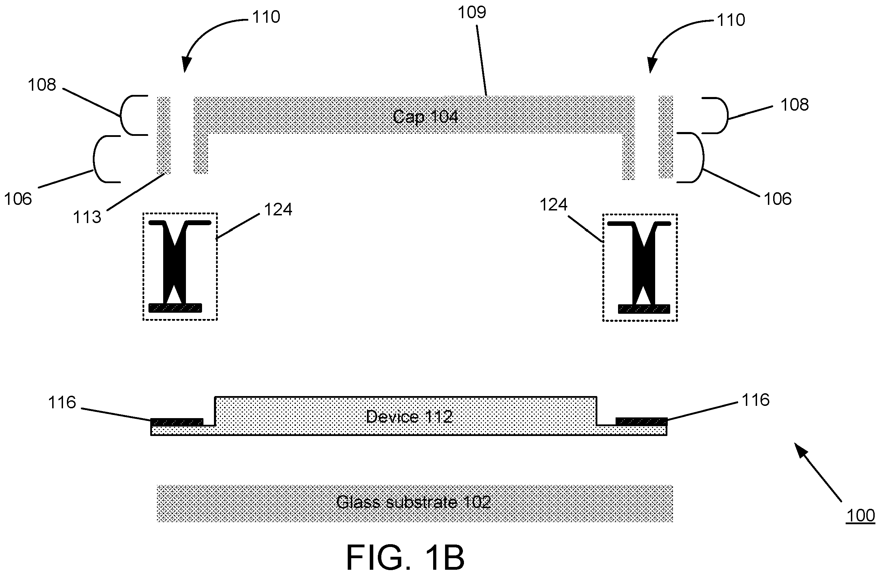

FIG. 1A illustrates an example of a hermetically sealed component 100 as described herein. FIG. 1B illustrates an exploded view of the component 100 shown in FIG. 1A. The hermetically sealed component 100 may comprise a glass substrate 102 and a glass cap 104. The glass cap 104 may comprise a cap side wall 106 and a cap upper wall 108. The glass cap 104 and the glass substrate 102 may be fabricated from any of a variety of glass materials, such as silicon dioxide (SiO₂), fused silica, silica glass, quartz, sodium-doped glass, and borosilicate glass. In other embodiments, the substrate and cap may consist of non-glass materials, such as Silicon (Si), Silicon Carbide (SiC) and Galium Nitride (GaN), although other non-glass materials may also be used. Although the example shown in FIGs. 1A and 1B identify a glass cap 104 with a distinct cap side wall 106 and a distinct cap upper wall 108, the glass cap 104 may be fabricated with the side wall and the upper wall consolidated to form a single integrated glass cap 104. Similarly, the side wall and the glass substrate 102 may be consolidated to form a single glass substrate unit with an integrated side wall.

The coefficient of thermal expansion (CTE) of the glass cap material should be substantially the same as the CTE of the glass substrate material, to minimize stress at any bonding joints between the glass cap 104 and the glass substrate 102.

A void 110 may be implemented in the glass cap 104, for example through the entire thickness of the glass cap 104 cap, as shown in FIGs. 1A and 1B, thereby creating a passageway through the glass cap 104. In the example of FIGs. 1A and 1B, the void 110 is shown formed in the glass cap 104 and side wall 106 from the top surface 109 of the glass cap to the bottom surface 113 of the side wall 106. In other embodiments, the void may be formed in other locations, for example laterally through the side wall 106 or up through the glass substrate 102. The void may be configured to be cylindrical with a circular cross-section, although in other embodiments the void may have a non-cylindrical cross-section, for example an elliptical cross section or an irregular cross section. Alternatively, the void may be characterized by a non-constant cross-sectional diameter from the top surface 109 of the glass cap to the bottom of the glass cap. The void may be characterized by a diameter of less than or equal to 500 µm in a plane defined by the upper wall top surface.

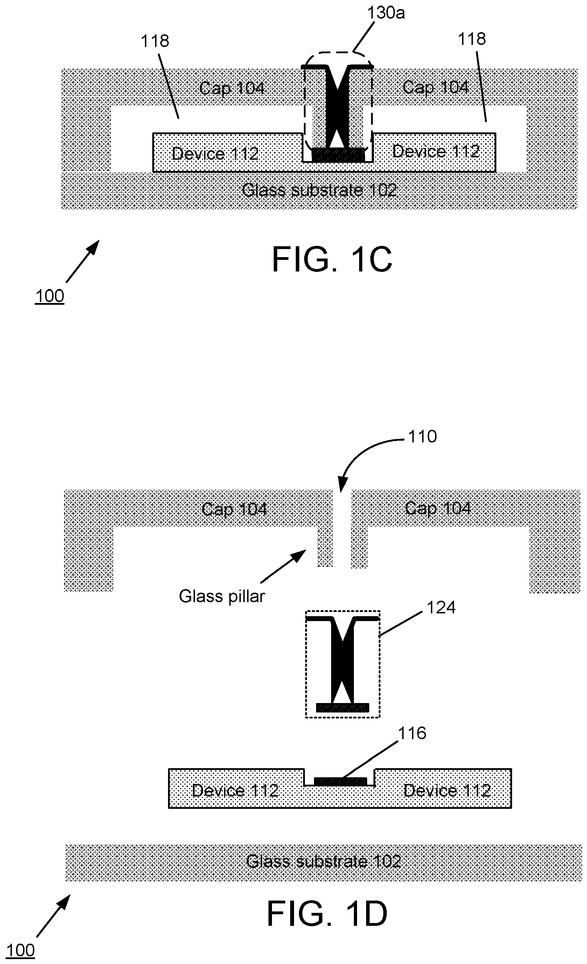

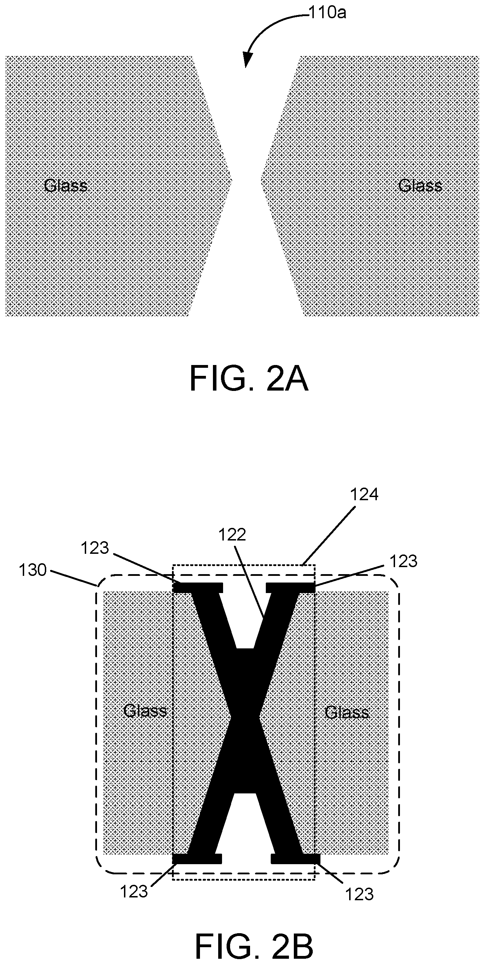

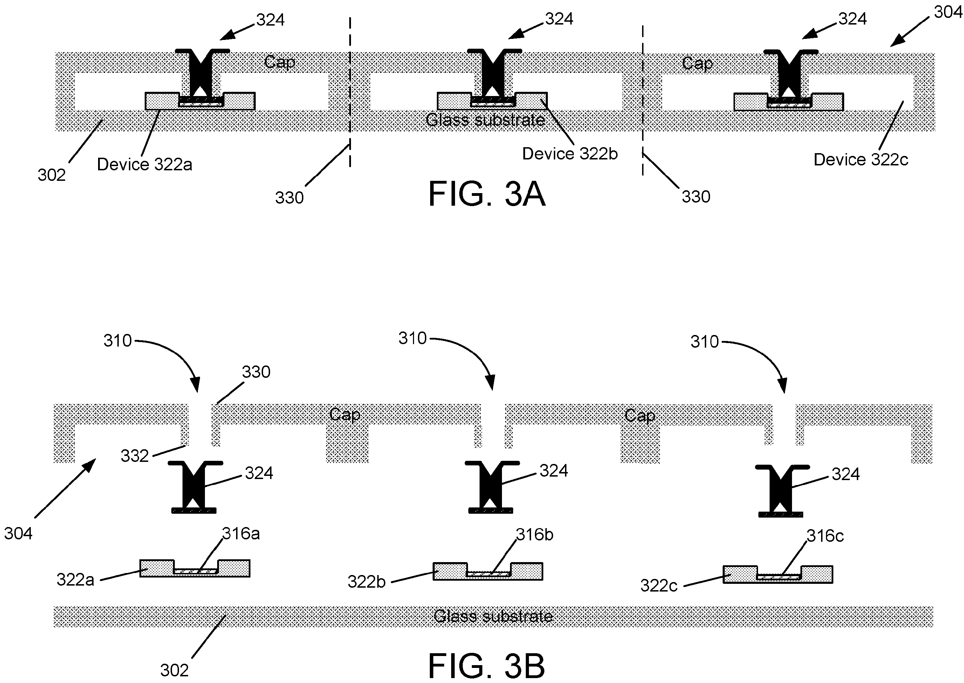

According to the invention, a cross-sectional view of the void 110 has an "hourglass" shape, as shown in FIGs 2A and 2B. A shaped metallic plug 122 may be disposed within the hourglass void 110a, thereby implementing a conformal pinched via (CPV) 124 in the glass cap or substrate. The metallic plug 122 may be formed in the hourglass void 110a by filling the hourglass void 110a by conformal plating from the side wall of the hourglass void 110a, until the plated thickness closes off the center region. The resulting shape of the metallic plug 122 is such that the hourglass void 110a is not completely filled across the top of the glass cap (or substrate) to the bottom of the glass cap (or substrate). In embodiments of the present invention, glass extends from the glass cap to form a glass pillar, as shown for example in FIG. 1C. In this case, the void extends through the outer (top) surface 330 of the glass cap (or substrate) and bottom surface 332 of the glass pillar, as depicted in the example embodiment shown in FIG. 3B. The CPV 124, along with the glass cap material surrounding it, is referred to herein as a CPV pillar 130.

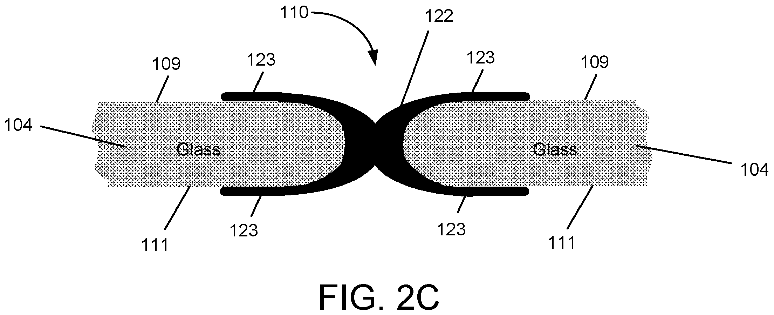

Portions 123 of the metallic plug 122 may extend along the top surface 109 and/or the bottom surface 111 of the glass cap 104. The portions 123 may be a redistribution layer (RDL). The redistribution layer may be selected from a variety of metals, for example gold, aluminum, and copper. This incomplete filling of the void by the metallic plug may contribute to accommodating relative differences in expansion and contraction of the glass cap 104 and the metallic plug 122 across operating and storage temperature ranges of the hermetically sealed component 100, thereby maintaining a hermetic seal at the CPV. In other words, the described configuration of the metallic plug may mitigate a difference between a coefficient of thermal expansion (CTE) of the glass cap and a CTE of the electrically conductive plug, thereby maintaining a hermetic seal at the CPV across operating and storage temperature ranges of the hermetically sealed component 100. FIG. 2C shows an alternative embodiment of the hourglass-shaped CPV 124.

The device 112 may be fabricated directly on the glass substrate 102. In an embodiment, the device is fabricated on the glass substrate 102 using a series deposition-lithography-pattern etch process. The device 112 may comprise at least one electrical port 116, through which electrical signals may enter and/or leave the device 112.

Although not shown, the glass substrate 102 and the glass cap 104 may be laterally extended beyond the device 112. At the laterally-outer portions of the device 112, the glass cap side walls may extend down to contact the glass substrate 102. In these extended regions, the glass cap 104 may be fixedly attached to the glass substrate 102 by, for example, metal thermo-compression bonding (also referred to herein as metal bonding), eutectic bonding, laser bonding, glass frit bonding, and anodic wafer bonding, although other bonding techniques known in the art may also be used.

Arranging the glass cap 104 and the glass substrate 102 with the side walls 106 therebetween, as shown in FIG. 1A, forms a cavity 118 that defines a device environment, isolated from an external environment 120. The CPV 124 may be electrically coupled to the device port 116 through, for example, metal thermo-compression bonding.

In some embodiments, the hermetically sealed component 100 may be configured with the side wall 106 being part of the glass substrate 102, rather than part of the glass cap 104, such that the glass cap 104 comprises only the cap upper wall 108. In such a configuration, the cavity 118 is formed by fixedly attaching the glass cap 104 (comprising only the cap upper wall 108) to the side walls of the glass substrate 102.

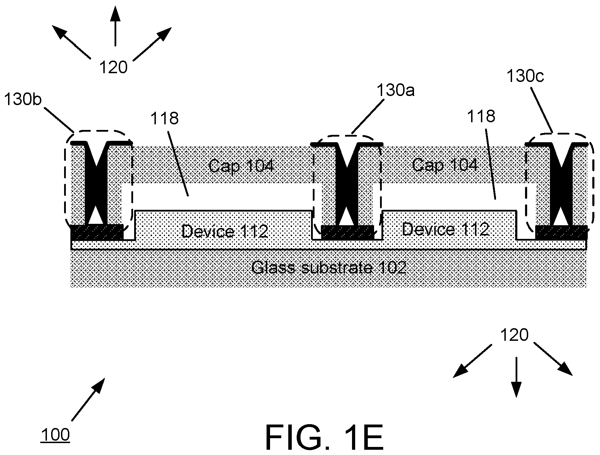

Although FIGs. 1A and 1B depict a hermetically sealed component 100 with CPV pillars on the periphery of the device 112, a CPV pillar may contact the device 112 in a middle portion of the device, instead of, or in addition to, the peripheral CPV pillars. FIG. 1C shows an example embodiment with a mid-region pillar 130a, and FIG. 1D shows an exploded view of the example embodiment of FIG. 1C. FIG. 1E illustrates an example embodiment with a mid-region pillar 130a and periphery pillars 130b, 130c.

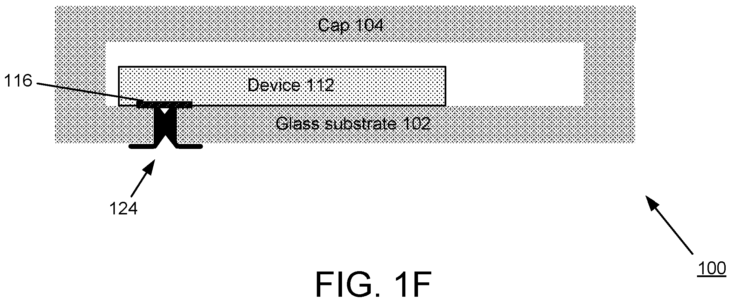

Further, as shown in FIG. 1F, a CPV 124 may be implemented through the glass substrate 102, as described for the glass cap. A CPV pillar through the glass substrate 102 may facilitate electrical signals to be coupled to a device port 116 on the underside of the device 112, and electrical communication through the glass substrate side of the hermetically sealed component 100. An embodiment with CPV pillars both in the glass cap and in the glass substrate may be used, for example, to interface to a component, such as a controller, mounted on the glass cap, while other external components may interface to the device 112 through the glass substrate.

In some embodiments, the device 112 may be a microelectromechanical system (MEMS)-based device. In other embodiments, the device 112 may be a nanoelectromechanical system (NEMS) device. In other embodiments, the device 112 may be an ohmic switch. The ohmic switch may be a single throw ohmic switch, or a multi-throw ohmic switch. The device may be fabricated of metal, polysilicon, or both.

The embodiments described herein may be configured to provide a hermetic seal, between the device environment within the cavity 118 and the external environment 120, capable of providing a measured helium leak rate that is less than 1.0 × 10⁻⁶ (atm-cm)³/second.

In some embodiments, the device 112 may comprise two or more electrical ports 116, with corresponding CPVs 124 configured to convey electrical signals to and from the device 112 outside of the device environment defined by the cavity 118. In other embodiments, the device 112 may comprise two or more devices fabricated on the glass substrate 102, each having device port(s) and corresponding CPV(s).

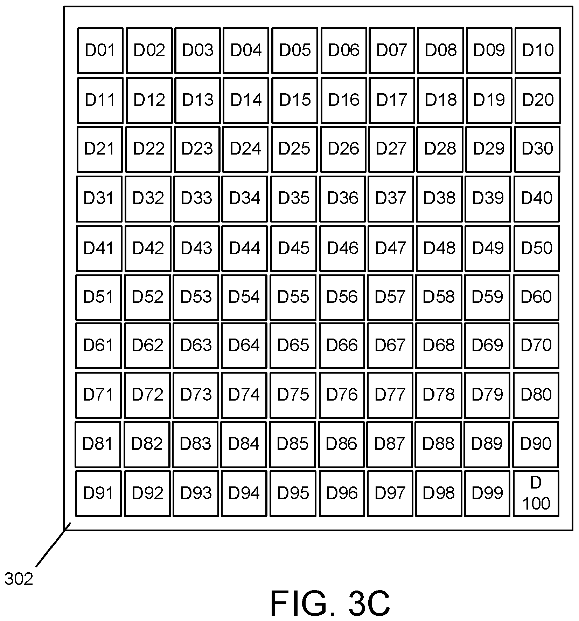

The described embodiments may be directed to two or more hermetically sealed components fabricated together in what is referred to as wafer-scale fabrication. Referring to FIG. 3A, two or more devices may be fabricated on a common glass substrate 302. FIG. 3B depicts an exploded view of the assembly shown in FIG. 3A. In the example embodiment depicted in FIGs. 3A and 3B, three devices, device 322a, 322b, 322c, are shown fabricated on glass substrate 302. Although only three devices are shown in this example embodiment for descriptive simplicity, more devices may be implemented in other embodiments. For example, FIG. 3C shows another example embodiment with 100 devices, from device D01 through device D100, each of which is attached to the common glass substrate 302 in a 10 × 10 grid pattern. FIG. 3C is a top-down view of the devices on the common glass substrate 302, contrasted with the sectional side-views of FIGs. 1A, 1B, 1C, 2, 3A and 3B.

In an embodiment, a single, composite glass cap structure 304 may comprise individual glass caps for each of the devices D01 through D100 attached to the glass substrate 302. Each individual glass cap may include at least one CPV 324 for conveying electrical signals to/from its respective device. As described herein, the CPV 324 is formed by a metallic plug disposed within an hourglass-shaped void 310 in the glass cap structure 304. Although the CPVs 324 shown in FIGs. 3A and 3B are CPV pillars arranged in the center of the device cavity, the CPV pillars may be disposed within the side walls instead of or in addition to the center positioned CPV pillars.

As described herein with respect to FIGs. 1A, 1B, 1C, 2, each individual glass cap of the composite cap structure 304 may have side walls associated with an upper cap wall to implement a device cavity, or the side walls may be associated with the common glass substrate 302 to facilitate the device cavity.

The composite glass cap structure 304 may be fixedly attached to the common glass substrate 302, which hosts the devices 322a, 322b, 322c with device ports 316a, 316b, 316c, as shown in FIG. 3A, thereby forming an assembly of two or more individual device packages. Three individual device packages are formed in the example of FIG. 3A. Each individual device 322n (where 'n' is an index from 1 to N, where N denotes the total number of devices being packaged), and its respective individual glass cap and individual glass substrate, may be separated from its neighbors in the combined assembly (i.e., composite glass cap, glass substrate and device) by cutting at the delineations 330 shown in FIG. 3A. Such cutting may be performed by any of various methods of accomplishing integrated circuit wafer die as is known in the art. In a grid array of packages, as depicted in FIG. 3C, orthogonal cuts (e.g., in the `x' direction and 'y' direction, where the x-y plane is parallel to the surface of the common glass substrate 302) are made across the assembly, to separate individual Dn package elements.

Although the example embodiments described herein depict a single device packaged within a hermetically sealed device environment, the techniques described herein may alternatively be used to hermetically seal two or more devices within a common device environment.

A device packaged as described herein may include a MEMS-based or a NEMS-based device, although other types of devices may also be packaged according to the described embodiments. Specific types of MEMS or NEMS based devices may include a single-pole-single-throw switch, a single-pole-multi-throw switch, a multi-pole-single throw switch, or a multi-pole-multi-pole switch. An advantage to the described embodiments is that electrical signal paths to switch poles and switch throw ports do not need to follow a purely two-dimensional path, e.g., along the surface of the glass substrate.

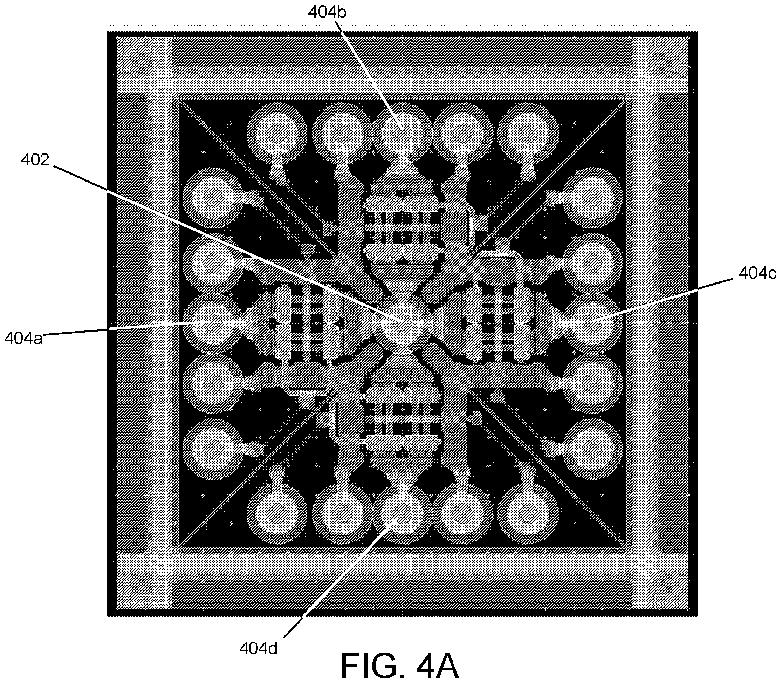

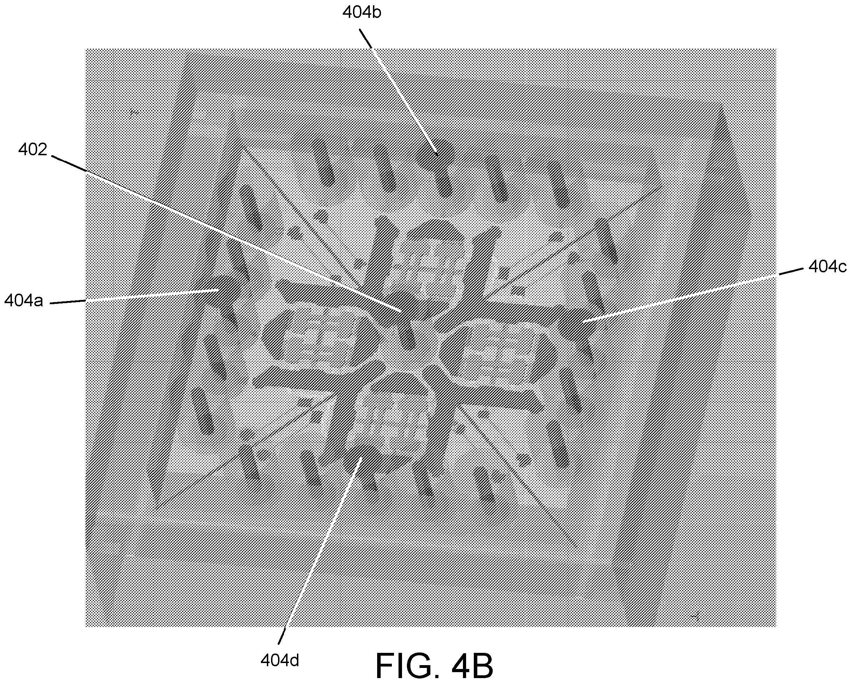

An example symmetrical single-pole, four-throw (SP4T) MEMS switch is shown in a top view in FIG. 4A, and in an isometric view in FIG. 4B. The pole of the switch is situated centrally, with the four throws distributed symmetrically about the pole (to the top of the pole, to the bottom of the pole, to the left of the pole, and to the right of the pole). A pole CPV 402 is situated in the package glass cap directly above the pole port of the SP4T switch. Throw poles 404a, 404b, 404c, 404d are situated at each of the respective throw ports. Compared to signal distribution architectures that are restricted to two-dimensional routing, the required physical substrate space of this example embodiment is substantially reduced, because the center signal connection at CPV 402 is used for single pole port. Accordingly, no space needs to be reserved on the MEMS wafer for the single pole port signal trace routing. This direct access to the switch pole port may result in improved switch performance because of a shorter distance from the pole port to throw ports. All electrical paths are identical from the pole port to each throw port, which facilitates identical behavior for each throw channel.

The examples described herein depict device ports connected to CPV pillar electrical ports situated in the package top cap, which facilitates direct "three-dimensional" access to the device ports. It should be understood, however, that the CPV pillar ports can be situated in other package locations, for example on the side walls. Further, one or more package electrical ports may be non-CPV ports, providing traditional two-dimensional access to device ports at the periphery of the device, in addition to the CPV pillar ports.

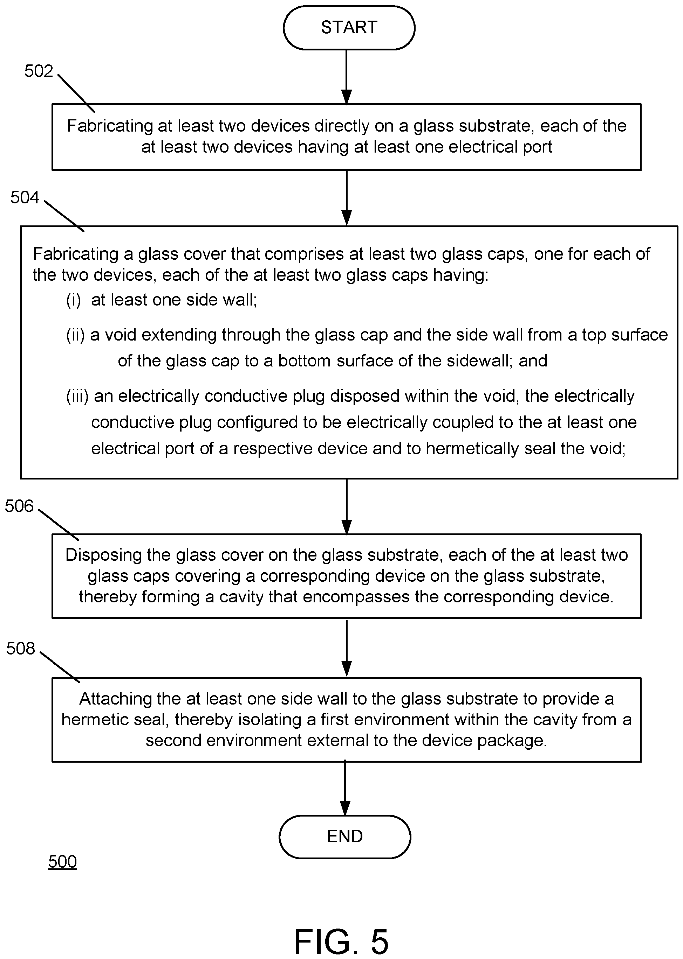

FIG. 5 illustrates an example embodiment of a method 500 of fabricating a plurality of device packages, which may comprise attaching 502 at least two devices to a glass substrate. Each of the at least two devices may comprise at least one electrical port. The method 500 may further comprise fabricating 504 a glass cover that comprises at least two glass caps, one for each of the two devices. Each of the at least two glass caps may have an upper wall and at least one side wall. The upper wall may have a void extending through the upper wall from an upper wall top surface to an upper wall bottom surface. Each of the glass caps may further have an electrically conductive plug disposed within the void, the electrically conductive plug hermetically sealing the void. Each of the glass caps may further have a conductor configured to electrically couple the electrically conductive plug to the electrical port. The method may further comprise disposing 506 the glass cover on the glass substrate. Each of the glass caps may cover a corresponding device on the glass substrate, thereby forming a cavity that encompasses the corresponding device. The method may further comprise attaching 508 the at least one side wall to the glass substrate to provide a hermetic seal, thereby isolating a first environment within the cavity from a second environment external to the device package.

While example embodiments have been particularly shown and described, it will be understood by those skilled in the art that various changes in form and details may be made therein without departing from the scope of the embodiments encompassed by the appended claims.

## Claims

1. A hermetically sealed component (100), comprising:
a glass substrate (102);
a device (112) disposed on the glass substrate, the device having at least one electrical port;
a glass cap (104) having at least one side wall (106), each of the glass substrate and the glass cap comprising one or more of (i) silicon dioxide, (ii) fused silica, (iii) silica glass, and (iv) quartz;
a glass pillar extending out from a bottom surface of the glass cap;
an hourglass-shaped void (110) extending through the glass cap and the glass pillar from a top surface of the glass cap to a bottom surface of the glass pillar; and
an electrically conductive plug (122) disposed within the void, the electrically conductive plug configured to be electrically coupled to the at least one electrical port and to hermetically seal the void, the electrically conductive plug and the void configured to form a conformal pinched via;
the glass cap and the glass substrate arranged with the at least one side wall disposed therebetween, to form a cavity (118) encompassing the device, the at least one side wall contacting the glass substrate and the glass cap to provide a hermetic seal, such that a first environment within the cavity is isolated from a second environment external to the cavity, and the electrically conductive plug contacting the electrical port.

2. The hermetically sealed component of claim 1, wherein the device is one of (i) a microelectromechanical system-based device, and (ii) a nanoelectromechanical system device and (iii) an ohmic switch.

3. The hermetically sealed component of claim 1, wherein the hermetic seal is configured such that a measured helium leak rate is less than 1.0 × 10⁻⁶ (atm-cm)³/second.

4. The hermetically sealed component of claim 1, wherein the glass cap further comprises a re-distribution layer disposed on a top surface of the glass cap and electrically coupled to the electrically conductive plug, wherein the re-distribution layer preferably comprises at least one of gold, aluminum, and copper.

5. The hermetically sealed component of claim 1, wherein the void has a diameter less than 500 µm in a plane defined by the top surface of the glass cap.

6. The hermetically sealed component of claim 1, wherein:
a portion of the cavity, defined by the glass cap and the at least one side wall, is formed such that the glass cap and the at least one side wall comprise a single, integrated component; or
a portion of the cavity, defined by the glass substrate and the at least one side wall, is formed such that the glass substrate and the at least one side wall comprise a single, integrated component.

7. The hermetically sealed component of claim 1, wherein the device comprises one of (i) a single throw ohmic switch and (ii) a multi-throw ohmic switch, and preferably the device consists of metal, polysilicon, or both.

8. The hermetically sealed component of claim 1, wherein the electrically conductive plug of the conformal pinched via expands or contracts to mitigate a difference between a coefficient of thermal expansion of the glass cap and a coefficient of thermal expansion of the electrically conductive plug.

9. The hermetically sealed component of claim 1, further comprising:
an additional void extending through the glass substrate from a bottom surface of the glass substrate to a top surface of the glass substrate; and
an additional electrically conductive plug disposed within the void, the additional electrically conductive plug configured to be electrically coupled to an additional one of the at least one electrical port, and to hermetically seal the void.

10. A hermetically sealed component of claim 1, further comprising:
a further device disposed on the glass substrate, the further device having at least one electrical port; and
a glass cover (304) comprising the glass cap and a glass cap for the further device, each of the glass caps having:
(i) at least one side wall, each of the glass substrate and the glass cap comprising one or more of (i) silicon dioxide, (ii) fused silica, (iii) silica glass, and (iv) quartz;
(ii) a glass pillar extending out from a bottom surface of the glass cap;
(iii) an hourglass-shaped void extending through the glass cap and the glass pillar from a top surface of the glass cap to a bottom surface of the glass pillar; and
(iv) an electrically conductive plug disposed within the void, the electrically conductive plug configured to be electrically coupled to the at least one electrical port of a respective device and to hermetically seal the void, the electrically conductive plug and the void configured to form a conformal pinched via;
the glass cover disposed on the glass substrate such that each of the glass caps covers a corresponding device on the glass substrate to form a cavity encompassing the device, the at least one side wall attached to the glass substrate to provide a hermetic seal, such that a first environment within the cavity is isolated from a second environment external to the device package.

11. The hermetically sealed component of claim 1, wherein the device is:
a symmetrical switch having at least one pole corresponding to a first contact and at least two throws associated with at least a second contact and a third contact, the symmetrical switch disposed on a surface of the glass substrate, the second contact and the third contact symmetrically distributed about the first contact; or
a single pole, single throw switch having a pole corresponding to a first contact and a throw associated with at least a second contact, the switch disposed on a surface of the glass substrate; or
a symmetrically configured device having at least a first contact, a second contact, and a third contact, the symmetrically configured device disposed on a surface of the glass substrate, the second contact and the third contact symmetrically distributed about the first contact with respect to the surface of the glass substrate.

12. A method of fabricating a plurality of device packages, comprising:
fabricating at least two devices (322) directly on a glass substrate (302), each of the at least two devices having at least one electrical port;
fabricating a glass cover (304) that comprises at least two glass caps (104), one for each of the two devices, each of the at least two glass caps having:
(i) at least one side wall (106);
(ii) a glass pillar extending out from a bottom surface of the glass cap;
(iii) an hourglass-shaped void (110) extending through the glass cap and the glass pillar from a top surface of the glass cap to a bottom surface of the glass pillar; and
(iv) an electrically conductive plug (122) disposed within the void, the electrically conductive plug configured to be electrically coupled to the at least one electrical port of a respective device and to hermetically seal the void, the electrically conductive plug and the void configured to form a conformal pinched via;
each of the glass substrate and the glass cap comprising one or more of (i) silicon dioxide, (ii) fused silica, (iii) silica glass, and (iv) quartz;
disposing the glass cover on the glass substrate, each of the at least two glass caps covering a corresponding device on the glass substrate, thereby forming a cavity (118) that encompasses the corresponding device;
attaching the at least one side wall of each glass cap to the glass substrate to provide a hermetic seal, thereby isolating a first environment within the cavity from a second environment external to the device package; and
electrically coupling each of the electrically conductive plugs to a respective electrical port.

13. The method of claim 12, further comprising fabricating the at least two devices directly on the glass substrate by integrating the at least two devices on the glass substrate using a series deposition-lithography-pattern etch process.

14. The method of claim 11, further comprising electrically coupling the electrically conductive plug to the at least one electrical port by metal thermo-compression bonding.

15. The method of claim 11, further comprising implementing a bond between the side wall and one or both of the glass cap and the glass substrate by one of (i) metal compression, (ii) eutectic bonding, (iii) laser bonding, (iv) glass frit, and (v) anodic wafer bonding.

## Patentansprüche

1. Hermetisch abgedichtete Komponente (100), die Folgendes umfasst:
ein Glassubstrat (102);
eine auf dem Glassubstrat angeordnete Vorrichtung (112), wobei die Vorrichtung mindestens einen elektrischen Anschluss aufweist;
eine Glaskappe (104) mit mindestens einer Seitenwand (106), wobei jedes von dem Glassubstrat und der Glaskappe eines oder mehrere von (i) Siliziumdioxid, (ii) Kieselglas, (iii) Quarzglas und (iv) Quarz umfasst;
eine Glassäule, die sich von einer unteren Fläche der Glaskappe aus erstreckt;
einen sanduhrförmigen Hohlraum (110), der sich durch die Glaskappe und die Glassäule von einer oberen Fläche der Glaskappe zu einer unteren Fläche der Glassäule erstreckt; und
einen innerhalb von dem Hohlraum angeordneten elektrisch leitfähigen Stecker (122), wobei der elektrisch leitfähige Stecker zum elektrischen Koppeln mit dem mindestens einen elektrischen Anschluss und zum hermetischen Abdichten des Hohlraums konfiguriert ist, wobei der elektrisch leitfähige Stecker und der Hohlraum zum Bilden einer konformen gequetschten Durchkontaktierung konfiguriert sind;
wobei die Glaskappe und das Glassubstrat mit der mindestens einen Seitenwand angeordnet sind, die dazwischen angeordnet ist, um eine die Vorrichtung umgebende Kavität (118) zu bilden, wobei die mindestens eine Seitenwand das Glassubstrat und die Glaskappe berührt, um eine hermetische Abdichtung bereitzustellen, sodass eine erste Umgebung innerhalb der Kavität von einer zweiten Umgebung außerhalb der Kavität isoliert ist, und wobei der elektrisch leitfähige Stecker den elektrischen Anschluss berührt.

2. Hermetisch abgedichtete Komponente nach Anspruch 1, wobei die Vorrichtung eines von (i) einer Vorrichtung auf der Basis eines mikroelektromechanischen Systems, und (ii) einer Vorrichtung eines nanoelektromechanischen Systems und (iii) einem ohmschen Schalter ist.

3. Hermetisch abgedichtete Komponente nach Anspruch 1, wobei die hermetische Abdichtung so konfiguriert ist, dass eine gemessene Heliumleckrate weniger als 1,0 × 10⁻⁶ (atm-cm)³/Sekunde beträgt.

4. Hermetisch abgedichtete Komponente nach Anspruch 1, wobei die Glaskappe ferner eine Umverteilungsschicht umfasst, die auf einer oberen Fläche der Glaskappe angeordnet und elektrisch mit dem elektrisch leitfähigen Stecker gekoppelt ist, wobei die Umverteilungsschicht vorzugsweise mindestens eines von Gold, Aluminium und Kupfer umfasst.

5. Hermetisch abgedichtete Komponente nach Anspruch 1, wobei der Hohlraum einen Durchmesser von weniger als 500 µm in einer Ebene aufweist, die durch die obere Fläche der Glaskappe definiert ist.

6. Hermetisch abgedichtete Komponente nach Anspruch 1, wobei:
ein Teil der Kavität, definiert durch die Glaskappe und die mindestens eine Seitenwand, so ausgebildet ist, dass die Glaskappe und die mindestens eine Seitenwand eine einzige, integrierte Komponente umfassen; oder
ein Teil der Kavität, definiert durch das Glassubstrat und die mindestens eine Seitenwand, so ausgebildet ist, dass das Glassubstrat und die mindestens eine Seitenwand eine einzige integrierte Komponente umfassen.

7. Hermetisch abgedichtete Komponente nach Anspruch 1, wobei die Vorrichtung einen von (i) einem ohmschen Schalter mit einer Schaltstellung und (ii) einem ohmschen Schalter mit mehreren Schaltstellungen umfasst, und die Vorrichtung vorzugsweise aus Metall, Polysilizium oder beidem besteht.

8. Hermetisch abgedichtete Komponente nach Anspruch 1, wobei sich der elektrisch leitfähige Stecker der konformen gequetschten Durchkontaktierung ausdehnt oder zusammenzieht, um eine Differenz zwischen einem Wärmeausdehnungskoeffizienten der Glaskappe und einem Wärmeausdehnungskoeffizienten des elektrisch leitfähigen Steckers zu abzuschwächen.

9. Hermetisch abgedichtete Komponente nach Anspruch 1, die ferner Folgendes umfasst:
einen zusätzlichen Hohlraum, der sich durch das Glassubstrat von einer unteren Fläche des Glassubstrats zu einer oberen Fläche des Glassubstrats erstreckt; und
einen zusätzlichen innerhalb von dem Hohlraum angeordneten elektrisch leitfähigen Stecker, wobei der zusätzliche elektrisch leitfähige Stecker zum elektrischen Koppeln mit einem zusätzlichen des mindestens einen elektrischen Anschlusses und zum hermetischen Abdichten des Hohlraums konfiguriert ist.

10. Hermetisch abgedichtete Komponente nach Anspruch 1, die ferner Folgendes umfasst:
eine weitere auf dem Glassubstrat angeordnete Vorrichtung, wobei die weitere Vorrichtung mindestens einen elektrischen Anschluss aufweist; und
eine Glasabdeckung (304), die die Glaskappe und eine Glaskappe für die weitere Vorrichtung umfasst, wobei jede der Glaskappen Folgendes aufweist:
(i) mindestens eine Seitenwand, wobei jedes von dem Glassubstrat und der Glaskappe eines oder mehrere von (i) Siliziumdioxid, (ii), Kieselglas (iii) Quarzglas und (iv) Quarz umfasst;
(ii) eine Glassäule, die sich von einer unteren Fläche der Glaskappe aus erstreckt;
(iii) einen sanduhrförmigen Hohlraum, der sich durch die Glaskappe und die Glassäule von einer oberen Fläche der Glaskappe zu einer unteren Fläche der Glassäule erstreckt; und
(iv) einen innerhalb von dem Hohlraum angeordneten elektrisch leitfähigen Stecker, wobei der elektrisch leitfähige Stecker zum elektrischen Koppeln mit dem mindestens einen elektrischen Anschluss einer jeweiligen Vorrichtung und zum hermetischen Abdichten des Hohlraums konfiguriert ist, wobei der elektrisch leitfähige Stecker und der Hohlraum zum Bilden einer konformen gequetschten Durchkontaktierung konfiguriert sind;
wobei die Glasabdeckung so auf dem Glassubstrat angeordnet ist, dass jede der Glaskappen eine entsprechende Vorrichtung auf dem Glassubstrat abdeckt, um eine die Vorrichtung umgebende Kavität zu bilden, wobei die mindestens eine Seitenwand an dem Glassubstrat angebracht ist, um eine hermetische Abdichtung bereitzustellen, sodass eine erste Umgebung innerhalb der Kavität von einer zweiten Umgebung außerhalb des Vorrichtungsgehäuses isoliert ist.

11. Hermetisch abgedichtete Komponente nach Anspruch 1, wobei die Vorrichtung Folgendes ist:
ein symmetrischer Schalter mit mindestens einem Pol entsprechend einem ersten Kontakt, und mindestens zwei mindestens einem zweiten Kontakt und einem dritten Kontakt zugeordnete Schaltstellungen, wobei der symmetrische Schalter auf einer Oberfläche des Glassubstrats angeordnet ist, wobei der zweite Kontakt und der dritte Kontakt symmetrisch um den ersten Kontakt herum verteilt sind; oder
einen einpoligen Schalter mit einer Schaltstellung mit einem Pol entsprechend einem ersten Kontakt und einer mindestens einem zweiten Kontakt zugeordneten Schaltstellung, wobei der Schalter auf einer Oberfläche des Glassubstrats angeordnet ist; oder
eine symmetrisch konfigurierte Vorrichtung mit mindestens einem ersten Kontakt, einem zweiten Kontakt und einem dritten Kontakt, wobei die symmetrisch konfigurierte Vorrichtung auf einer Oberfläche des Glassubstrats angeordnet ist, wobei der zweite Kontakt und der dritte Kontakt symmetrisch um den ersten Kontakt herum in Bezug auf die Oberfläche des Glassubstrats verteilt sind.

12. Verfahren zum Herstellen einer Vielzahl von Vorrichtungsgehäusen, das Folgendes umfasst:
Herstellen von mindestens zwei Vorrichtungen (322) direkt auf einem Glassubstrat (302), wobei jede der mindestens zwei Vorrichtungen mindestens einen elektrischen Anschluss aufweist;
Herstellen einer Glasabdeckung (304), die mindestens zwei Glaskappen (104) umfasst, eine für jede der beiden Vorrichtungen, wobei jede der mindestens zwei Glaskappen Folgendes aufweist:
(i) mindestens eine Seitenwand (106);
(ii) eine Glassäule, die sich von einer unteren Fläche der Glaskappe aus erstreckt;
(iii) einen sanduhrförmigen Hohlraum (110), der sich durch die Glaskappe und die Glassäule von einer oberen Fläche der Glaskappe zu einer unteren Fläche der Glassäule erstreckt; und
(iv) einen innerhalb von dem Hohlraum angeordneten elektrisch leitfähigen Stecker (122), wobei der elektrisch leitfähige Stecker zum elektrischen Koppeln mit dem mindestens einen elektrischen Anschluss einer jeweiligen Vorrichtung und zum hermetischen Abdichten des Hohlraums konfiguriert ist, wobei der elektrisch leitfähige Stecker und der Hohlraum zum Bilden einer konformen gequetschten Durchkontaktierung konfiguriert sind;
wobei jedes von dem Glassubstrat und der Glaskappe eines oder mehrere von (i) Siliziumdioxid, (ii) Kieselglas, (iii) Quarzglas und (iv) Quarz umfasst;
Anordnen der Glasabdeckung auf dem Glassubstrat, wobei jede der mindestens zwei Glaskappen eine entsprechende Vorrichtung auf dem Glassubstrat abdeckt, wodurch eine die entsprechende Vorrichtung umgebende Kavität (118) gebildet wird;
Anbringen der mindestens einen Seitenwand jeder Glaskappe an dem Glassubstrat, um eine hermetische Abdichtung bereitzustellen, wodurch eine erste Umgebung innerhalb der Kavität von einer zweiten Umgebung außerhalb des Vorrichtungsgehäuses isoliert wird; und
elektrisches Koppeln jedes der elektrisch leitfähigen Stecker mit einem jeweiligen elektrischen Anschluss.

13. Verfahren nach Anspruch 12, das ferner das Herstellen der mindestens zwei Vorrichtungen direkt auf dem Glassubstrat durch Integrieren der mindestens zwei Vorrichtungen auf dem Glassubstrat unter Verwendung von einem Serienabscheidung-Lithographie-Muster-Ätzverfahren umfasst.

14. Verfahren nach Anspruch 11, das ferner das elektrische Koppeln des elektrisch leitfähigen Steckers mit dem mindestens einen elektrischen Anschluss durch Metall-Thermokompressionsbonden umfasst.

15. Verfahren nach Anspruch 11, das ferner das Implementieren einer Bindung zwischen der Seitenwand und einem oder beiden von der Glaskappe und dem Glassubstrat durch (i) Metallkompression, (ii) eutektisches Bonden, (iii) Laser-Bonden, (iv) Glasfritte und (v) anodisches Wafer-Bonden umfasst.

## Revendications

1. Composant hermétiquement scellé (100), comprenant :
un substrat en verre (102) ;
un dispositif (112) disposé sur le substrat en verre, le dispositif ayant au moins un port électrique ;
un couvercle en verre (104) ayant au moins une paroi latérale (106), chacun du substrat en verre et du couvercle en verre comprenant un ou plusieurs éléments parmi (i) le dioxyde de silicium, (ii) la silice fondue, (iii) le verre de silice et (iv) le quartz ;
un pilier en verre s'étendant à partir d'une surface inférieure du couvercle en verre ;
un vide en forme de sablier (110) s'étendant à travers le couvercle en verre et le pilier en verre à partir d'une surface supérieure du couvercle en verre jusqu'à une surface inférieure du pilier en verre ; et
une fiche électriquement conductrice (122) disposée à l'intérieur du vide, le fiche électriquement conductrice étant configurée pour être couplée électriquement à l'au moins un port électrique et pour sceller hermétiquement le vide, la fiche électriquement conductrice et le vide étant configurés pour former un via pincé conforme ;
le couvercle en verre et le substrat en verre agencés avec l'au moins une paroi latérale disposée entre eux, pour former une cavité (118) englobant le dispositif, l'au moins une paroi latérale étant en contact avec le substrat en verre et le couvercle en verre pour fournir un joint hermétique, de sorte qu'un premier environnement à l'intérieur de la cavité est isolé d'un deuxième environnement extérieur à la cavité, et la fiche électriquement conductrice étant en contact avec le port électrique.

2. Composant hermétiquement scellé selon la revendication 1, dans lequel le dispositif est un des éléments suivants : (i) un dispositif basé sur un système microélectromécanique, (ii) un dispositif de système nanoélectromécanique et (iii) un commutateur ohmique.

3. Composant hermétiquement scellé selon la revendication 1, dans lequel le joint hermétique est configuré de telle sorte qu'un taux de fuite d'hélium mesuré est inférieur à 1,0 × 10⁻⁶ (atm-cm)³/seconde.

4. Composant hermétiquement scellé selon la revendication 1, dans lequel le couvercle en verre comprend en outre une couche de redistribution disposée sur une surface supérieure du couvercle en verre et couplée électriquement à la fiche électriquement conductrice, dans lequel la couche de redistribution comprend de préférence au moins un parmi l'or, l'aluminium et le cuivre.

5. Composant hermétiquement scellé selon la revendication 1, dans lequel le vide a un diamètre inférieur à 500 µm dans un plan défini par la surface supérieure du couvercle en verre.

6. Composant hermétiquement scellé selon la revendication 1, dans lequel :
une partie de la cavité, définie par le couvercle en verre et l'au moins une paroi latérale, est formée de telle sorte que le couvercle en verre et l'au moins une paroi latérale comprennent un composant unique intégré ; ou
une partie de la cavité, définie par le substrat en verre et l'au moins une paroi latérale, est formée de telle sorte que le substrat en verre et l'au moins une paroi latérale comprennent un composant unique intégré.

7. Composant hermétiquement scellé selon la revendication 1, dans lequel le dispositif comprend un des éléments suivants : (i) un commutateur ohmique unidirectionnel et (ii) un commutateur ohmique multidirectionnel, et de préférence le dispositif est constitué de métal, de polysilicium, ou des deux à la fois.

8. Composant hermétiquement scellé selon la revendication 1, dans lequel la fiche électriquement conductrice du via pincé conforme se dilate ou se contracte pour atténuer une différence entre un coefficient de dilatation thermique du couvercle en verre et un coefficient de dilatation thermique de la fiche électriquement conductrice.

9. Composant hermétiquement scellé selon la revendication 1, comprenant en outre :
un vide supplémentaire s'étendant à travers le substrat en verre à partir d'une surface inférieure du substrat en verre jusqu'à une surface supérieure du substrat en verre ; et
une fiche supplémentaire électriquement conductrice disposée à l'intérieur du vide, la fiche supplémentaire électriquement conductrice étant configurée pour être couplée électriquement à un port supplémentaire de l'au moins un port électrique, et pour sceller hermétiquement le vide.

10. Composant hermétiquement scellé selon la revendication 1, comprenant en outre :
un dispositif additionnel disposé sur le substrat en verre, le dispositif additionnel ayant au moins un port électrique ; et
une couverture en verre (304) comprenant le couvercle en verre et un couvercle en verre pour le dispositif additionnel, chacun des couvercles en verre ayant :
(i) au moins une paroi latérale, chacun du substrat en verre et du couvercle en verre comprenant un ou plusieurs éléments parmi (i) le dioxyde de silicium, (ii) la silice fondue, (iii) le verre de silice, et (iv) le quartz ;
(ii) un pilier en verre s'étendant à partir d'une surface inférieure du couvercle en verre ;
(iii) un vide en forme de sablier s'étendant à travers le couvercle en verre et le pilier en verre à partir d'une surface supérieure du couvercle en verre jusqu'à une surface inférieure du pilier en verre ; et
(iv) une fiche électriquement conductrice disposée à l'intérieur du vide, la fiche électriquement conductrice étant configurée pour être couplée électriquement à l'au moins un port électrique d'un dispositif respectif et pour sceller hermétiquement le vide, la fiche électriquement conductrice et le vide étant configurés pour former un via pincé conforme ;
la couverture en verre étant disposée sur le substrat en verre de telle sorte que chacun des couvercles en verre recouvre un dispositif correspondant sur le substrat en verre pour former une cavité englobant le dispositif, l'au moins une paroi latérale étant fixée au substrat en verre pour fournir un joint hermétique, de telle sorte qu'un premier environnement à l'intérieur de la cavité est isolé d'un deuxième environnement extérieur au boîtier de dispositif.

11. Composant hermétiquement scellé selon la revendication 1, dans lequel le dispositif est :
un interrupteur symétrique ayant au moins un pôle correspondant à un premier contact et au moins deux positions associées à au moins un deuxième contact et un troisième contact, l'interrupteur symétrique étant disposé sur une surface du substrat en verre, le deuxième contact et le troisième contact étant répartis symétriquement autour du premier contact ; ou
un interrupteur unipolaire unidirectionnel ayant un pôle correspondant à un premier contact et une position associée à au moins un deuxième contact, l'interrupteur étant disposé sur une surface du substrat en verre ; ou
un dispositif à configuration symétrique comportant au moins un premier contact, un deuxième contact et un troisième contact, le dispositif à configuration symétrique étant disposé sur une surface du substrat en verre, le deuxième contact et le troisième contact étant répartis symétriquement autour du premier contact par rapport à la surface du substrat en verre.

12. Procédé de fabrication d'une pluralité de boîtiers de dispositifs, comprenant les étapes consistant à :
fabriquer au moins deux dispositifs (322) directement sur un substrat en verre (302), chacun des au moins deux dispositifs ayant au moins un port électrique ;
fabriquer une couverture en verre (304) qui comprend au moins deux couvercles en verre (104), un pour chacun des deux dispositifs, chacun des au moins deux couvercles en verre ayant :
(i) au moins une paroi latérale (106) ;
(ii) un pilier en verre s'étendant à partir d'une surface inférieure du couvercle en verre ;
(iii) un vide en forme de sablier (110) s'étendant à travers le couvercle en verre et le pilier en verre à partir d'une surface supérieure du couvercle en verre jusqu'à une surface inférieure du pilier en verre ; et
(iv) une fiche électriquement conductrice (122) disposée à l'intérieur du vide, la fiche électriquement conductrice étant configurée pour être couplée électriquement à l'au moins un port électrique d'un dispositif respectif et pour sceller hermétiquement le vide, la fiche électriquement conductrice et le vide étant configurés pour former un via pincé conforme ;
chacun du substrat en verre et du couvercle en verre comprenant un ou plusieurs éléments parmi (i) le dioxyde de silicium, (ii) la silice fondue, (iii) le verre de silice, et (iv) le quartz ;
disposer la couverture en verre sur le substrat en verre, chacun des au moins deux couvercles en verre recouvrant un dispositif correspondant sur le substrat en verre, formant ainsi une cavité (118) qui englobe le dispositif correspondant ;
fixer l'au moins une paroi latérale de chaque couvercle en verre au substrat en verre pour fournir un joint hermétique, isolant ainsi un premier environnement à l'intérieur de la cavité d'un deuxième environnement extérieur au boîtier de dispositif ; et
coupler électriquement chacune des fiches électriquement conductrices à un port électrique respectif.

13. Procédé selon la revendication 12, comprenant en outre la fabrication des au moins deux dispositifs directement sur le substrat en verre en intégrant les au moins deux dispositifs sur le substrat en verre en utilisant un processus de dépôt-lithographie-motif de gravure en série.

14. Procédé selon la revendication 11, comprenant en outre le couplage électrique de la fiche électriquement conductrice à l'au moins un port électrique par soudage par thermocompression métallique.

15. Procédé selon la revendication 11, comprenant en outre la mise en oeuvre d'une liaison entre la paroi latérale et un ou les deux du couvercle en verre et du substrat en verre par l'un des moyens suivants : (i) compression métallique, (ii) liaison eutectique, (iii) liaison laser, (iv) fritte de verre, et (v) liaison anodique d'une tranche.
